# EUROPEAN PATENT APPLICATION

(11) **EP 1 531 494 A2**
(43) Date of publication of application: **18.05.2005**
(21) Application number: 04078125.4
(22) Date of filing: 15.11.2004
(51) Int. Cl.: H01L 25/065

(54) **Double-sided multi-chip circuit component**

(30) Priority: 13.11.2003 US 707005
(71) Applicant: Delphi Technologies, Inc., Troy, MI 48007 (US)
(72) Inventor: Campbell, Robert J., Noblesville, IN 46060 (US); Gerbsch, Erich W., Cicero, IN 46034 (US)
(74) Representative: Denton, Michael John

(57) **Abstract**

A multi-chip circuit component comprising first and second substrate members (12,14), each of which are formed of an electrically-nonconductive material. Each substrate member (12,14) has oppositely-disposed first and second surfaces (22,24,46,48), with an outer layer (26,28) of thermally-conductive material on the first surface (22,24) thereof and electrically-conductive areas (36,38,40,42) on the second surface (46,48) thereof. At least two circuit devices (16,18) are present between the first and second substrate members (12,14), with each circuit device (16,18) having a first surface electrically contacting at least one of the electrically-conductive areas (36,38) of the first substrate member (12), and each circuit device (16,18) having a second surface electrically contacting a corresponding one of the electrically-conductive areas (40,42) of the second substrate member (14). First lead members (32,34) are electrically coupled to the electrically-conductive areas (36,38) of the first substrate member (12), and second lead members (30) are electrically coupled to the electrically-conductive areas (40,42) of the second substrate member (14).

## Description

### TECHNICAL FIELD

The present invention generally relates to circuit board components, and more particularly to a multi-chip circuit component whose package size is minimized while also having heat transfer paths at opposite surfaces of the component.

### BACKGROUND OF THE INVENTION

Various types of circuit board components have been specifically developed for high current and high power applications, such as hybrid and electric vehicles. Such components often comprise a semiconductor device, such as a diode, thyristor, MOSFET (metal oxide semiconductor field effect transistor), IGBT (isolated gate bipolar transistor), resistors, etc., depending on the particular circuit and use desired. Vertical devices are typically formed in a semiconductor (e.g., silicon) die having metallized electrodes on its opposite surfaces, e.g., a MOSFET or IGBT with a drain/collector electrode on one surface and gate and source/emitter electrodes on its opposite surface. The die is mounted on a conductive pad for electrical contact with the drain/collector electrode, with connections to the remaining electrodes on the opposite surface often being made by wire bonding. The pad and wires are electrically connected to a leadframe whose leads project outside a protective housing that is often formed by overmolding the lead frame and die.

Components of the type described above include well-known industry standard package outlines, such as the TO220 and TO247 cases, which are pre-packaged integrated circuit (IC) components whose leads are adapted for attachment (e.g., by soldering) to a printed circuit board (PCB). The overmolded housings of these packages protect the die, wire bonds, etc., while typically leaving the lower surface of the conductive pad exposed to provide a thermal and/or electrical path out of the package. Such a path allows the package to be connected to an electrical bus for electrical connection to the PCB, or a heat-sinking mass for dissipating heat from the package. If electrical isolation of the path is necessary, a non-electrically conductive heat-sinking pad is provided between the package and heat-sinking mass. In doing so, the heat-sinking pad increases the thermal resistance of the path, typically on the order of 0.1 to 0.5 °C/watt.

A further drawback of packages of the type described above is their size. As an example, in certain high current hybrid vehicle applications, arrays of packages containing MOSFET's in a three-phase configuration are utilized, with two or three devices in parallel per switch. The resulting assembled array may contain, for example, sixteen to twenty-four packages, requiring a relatively large area on the PCB. In high current, high voltage (e.g., 150 to 400 V) hybrid vehicle applications, this situation is exacerbated by the need for paired sets of IGBT's and diodes, with the resulting assembled array twice as many individual packages.

In view of the above, there is an ongoing need for circuit components that are packaged in such a way to reduce their overall size while also meeting both current and thermal management requirements.

### BRIEF SUMMARY OF THE INVENTION

The present invention provides a multi-chip circuit component suitable for high power and high current applications, including hybrid and electric vehicles. The multi-chip circuit component reduces part count and the overall size of a circuit assembly containing a plurality of the components, while also exhibiting improved thermal performance through the presence of multiple thermal paths that are electrical isolated from the current-carrying elements of the component.

The multi-chip circuit component comprises first and second substrate members, each of which are formed of an electrically-nonconductive (dielectric) material. Each of the substrate members has oppositely-disposed first and second surfaces, with a layer of thermally-conductive material on the first surface thereof and electrically-conductive areas on the second surface thereof. At least two of the electrically-conductive areas of the first substrate member are electrically separated from each other. At least two circuit devices are present between the first and second substrate members, with each circuit device having a first surface electrically contacting at least one of the electrically-conductive areas of the first substrate member, and each circuit device having a second surface electrically contacting a corresponding one of the electrically-conductive areas of the second substrate member. The component further comprises first lead members electrically coupled to the electrically-conductive areas of the first substrate member, and second lead members electrically coupled to the electrically-conductive areas of the second substrate member.

In view of the above, the multi-chip circuit component of this invention is suitable for use in high power and high current applications as a result of providing heat transfer surfaces through the first surfaces of each substrate member. The heat transfer surfaces are electrically isolated from the circuit devices of the component as a result of the dielectric material used to form the substrates. The integration of multiple device chips into a single circuit component reduces part count and reduces the overall size of a circuit assembly, particularly one that requires a plurality of the components.

Other objects and advantages of this invention will be better appreciated from the following detailed description.

### BRIEF DESCRIPTION OF THE DRAWINGS

Figure 1 is an exploded view of a multi-chip component in accordance with the present invention.
Figure 2 is a perspective view of the upper substrate shown in Figure 1.
Figures 3 and 4 are top and front views, respectively, of the component of Figure 1.

### DETAILED DESCRIPTION OF THE INVENTION

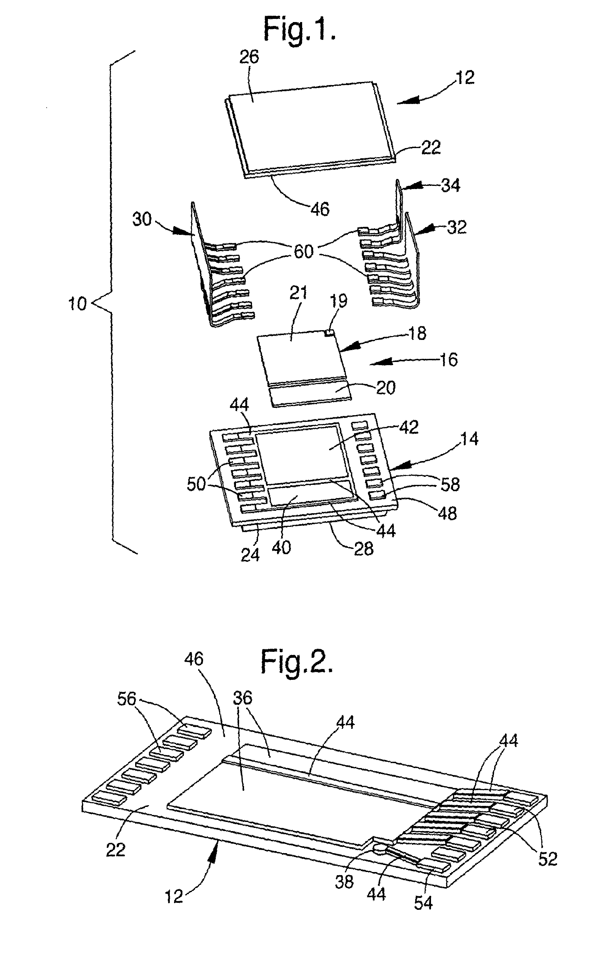

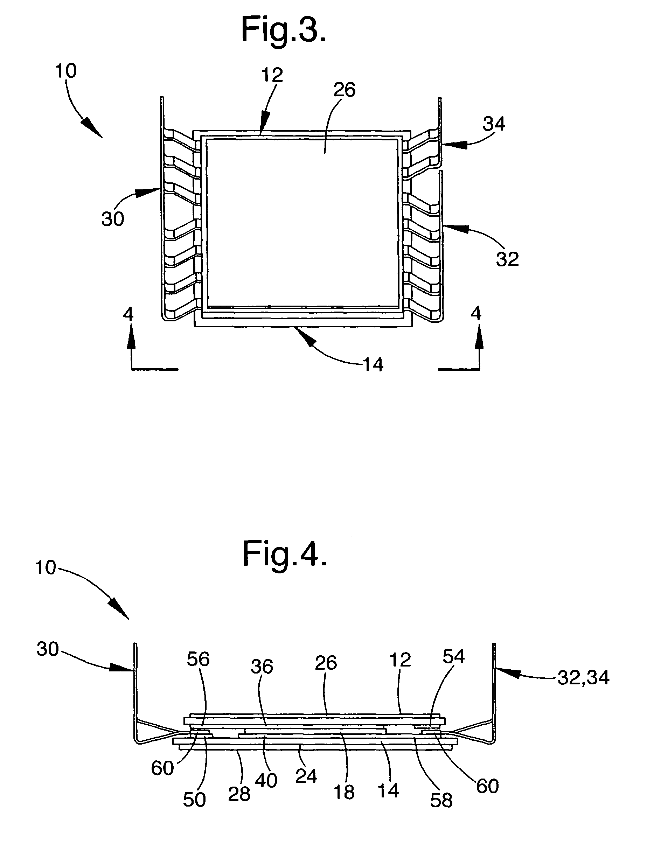

A multi-chip circuit component 10 in accordance with an embodiment of the present invention is shown in Figures 1 through 4. The component 10 is shown as comprising a pair of substrates 12 and 14, two circuit devices 16 and 18, and three sets of leads 30, 32 and 34. From the following it will be appreciated that the component 10 shown in the Figures is intended to be representative of an embodiment of the invention, and that the number, configuration, and orientation of the elements of the component 10 can differ from that shown in the Figures, e.g., the devices 16 and 18 can be rotated in different directions to optimize various parameters, such as package inductance.

The substrates 12 and 14 are formed of an electrically-nonconductive material, preferably a ceramic material of the type commonly used in electronic systems such as alumina (Al₂O₃), aluminum nitride (AlN), silicon nitride (SiN), beryllium oxide (BeO), or an insulated metal substrate (IMS) material. Ceramic materials vary in thermal performance, such that the selection of a particular ceramic material for the substrates 12 and 14 will depend at least in part on the thermal requirements of the specific application for the component 10. Each of the outward-facing surfaces 22 and 24 of the substrates 12 and 14 have an outer layer 26 and 28, respectively, of thermally-conductive material. The outer layers 26 and 28 may be formed of a solderable material, such as copper, copper alloy, plated (e.g., NiAu) aluminum, etc., to permit soldering of the component 10 to heatsinks (not shown) or other suitable structures. If solder is not required for attachment, such as pressure attachment, other materials can be used for the outer layers 26 and 28. Furthermore, it is foreseeable that the outer layers 26 and 28 could be eliminated, with the benefit of reducing the thermal resistance of the thermal path through these layers 26 and 28, and therefore reduced component temperature.

For convenience, the devices 16 and 18 will be discussed as a diode and IGBT, respectively, though other combinations of devices could be used, such as a pair of transistors, for example, a pair of IGBT's or a pair of MOSFET's. As conventional, the diode 16 and IGBT 18 are each preferably formed in a semiconductor die, such as silicon. Electrodes (not shown) are formed on the lower surfaces of their respective dies, with the electrode of the transistor 18 being a collector electrode. As also conventional, the diode 16 and IGBT transistor 18 have electrodes on the upper surfaces of their dies, with the diode 16 having a single upper electrode 20 while two electrodes are present on the transistor 18 in the form of gate and emitter electrodes 19 and 21. Those skilled in the art will appreciate that, while in the following discussion the transistor 18 is discussed as an IGBT with collector, emitter and gate electrodes, the discussion is equally applicable to a MOSFET, in which case the electrodes would be drain, source and gate electrodes, respectively. To accommodate one or more MOSFET's (or other combination of devices), only minor changes to the substrates 12 and 14 and leads 30, 32 and 34 would be required, as will become evident.

Electrical connections of the leads 30, 32 and 34 to the electrodes of the diode 16 and transistor 18 are achieved through electrically-conductive contact areas 36, 38, 40, and 42 defined on the inward-facing surfaces 46 and 48 of the substrates 12 and 14, respectively. On the substrate 12, two contact areas 36 are defined to individually register with the upper electrode 20 of the diode 16 and the emitter electrode 21 of the IGBT 18, and the area 38 is provided for registration with the gate electrode 19 of the IGBT 18. On the substrate 14, the areas 40 and 42 register with the lower electrode of the diode 16 and the collector electrode of the IGBT 18, respectively. Electrically-conductive bonding between the areas 36, 38, 40 and 42 and their respective electrodes is preferably achieved with solder connections. The contact areas 36 on the substrate 12 are depicted as being formed by a single conductive layer, e.g., a copper foil, as are the areas 40 and 42 on the substrate 14. A suitable solder stop material 44 is deposited to delineate the areas 36, 40 and 42, such that the devices 16 and 18 correctly position themselves between the substrates 12 and 14 during soldering. The configurations of the areas 36, 38, 40 and 42 and the placement of the solder stop 44 can be modified to match the geometry of a variety of integrated circuit devices incorporated into the component 10.

The leads 30, 32 and 34 are adapted for connecting the component 10 to an electrical bus or other device utilized in the particular application. The leads 30, 32 and 34 can be formed of stamped copper or copper alloy, though other methods of construction are possible. The leads 30, 32 and 34 are depicted as being of a type suitable for use in high current applications (e.g., 200 amperes). For lower current applications, individual lead pins can be used. Each lead 30, 32 and 34 is shown as comprising a plurality of fingers 60 through which electrical and physical connection is made with the diode 16 and IGBT 28. In particular, the lead 30 is electrically coupled to the areas 40 and 42 (and therefore the lower electrode of the diode 16 and the collector electrode of the IGBT 18) through bond pads 50 on the lower substrate 14. The pads 50 are shown as being formed by the same conductive layer as the areas 40 and 42, and delineated with solder stop 44. The lead 30 is preferably soldered to the bond pads 50 as well as electrically-isolated pads 56 on the lower surface 46 of the upper substrate 12. Similarly, the leads 32 and 34 are bonded (e.g., soldered) to bond pads 52 and 54 on the upper substrate 12, in combination with electrically-isolated pads 58 on the lower substrate 14. The pads 52 are shown as being formed by the same conductive layer as the areas 36, the pad 54 is shown as being formed by the same conductive layer as the area 38, and each is delineated with solder stop 44.

In view of the above construction, the component 10 conducts current and uniformly extracts current across its entire face, instead of wire bond connection sites, and therefore has the ability to carry higher currents with less temperature rise than conventional wire bonded and ribbon bonded devices. Also by avoiding wire and ribbon bonding techniques, the component 10 can be readily adapted to enclose various types and configurations of devices. The component 10 also has the advantage of being able to dissipate heat in two directions, namely, up through the upper substrate 12 and/or down through the lower substrate 14. If both substrates 12 and 14 are used to dissipate heat, the temperature rise of the component 10 can potentially be reduced by about one-half. The solderable outer layers 26 and 28 of the substrates 12 and 14 are isolated from the circuit devices 16 and 18 by the substrates 12 and 14. By providing electrically-isolated top and bottom surfaces in this manner, the need for discrete heatsink electrical-isolation pads can be avoided.

It can also be seen from the above that the component 10 does not require a plastic overmold, in that the circuit devices 16 and 18 are protectively enclosed by the substrate 12 and 14. Avoiding a plastic overmold reduces internal differences in coefficients of thermal expansion (CTE) within the component 10, as well as CTE mismatches with components and substrates contacting by the component 10, thereby improving component life during temperature cycling. If desired, a compliant dielectric encapsulating material can be placed around the perimeter of the component package to seal the edges of the substrates 12 and 14 and the gap therebetween, thereby protecting against contaminant intrusion and improving the electrical isolation properties of the package.

While the invention has been described in terms of a preferred embodiment, it is apparent that other forms could be adopted by one skilled in the art. Accordingly, the scope of the invention is to be limited only by the following claims.

## Claims

1. A multi-chip circuit component (10) comprising first and second substrate members (12,14) formed of electrically-nonconductive material, the first substrate member (12) having oppositely-disposed first and second surfaces (22,46), an outer layer (26) of thermally-conductive material on the first surface (22), and electrically-conductive areas (36,38) on the second surface (46), at least two of the electrically-conductive areas (36,38) being electrically separated from each other with first lead members (32,34) electrically coupled thereto, the second substrate member (14) having oppositely-disposed first and second surfaces (24,48), an outer layer (28) of thermally-conductive material on the first surface (24) of the second substrate member (14), and at least two electrically-conductive areas (40,42) on the second surface (48) of the second substrate member (14), the electrically-conductive areas (40,42) having second lead members (30) electrically coupled thereto, **characterized in that**:
at least two circuit devices (16,18) are disposed between the first and second substrate members (12,14), each of the circuit devices (16,18) having a first surface electrically contacting at least one of the electrically-conductive areas (36,38) of the first substrate member (12), each of the circuit devices (16,18) having a second surface electrically contacting a corresponding one of the electrically-conductive areas (40,42) of the second substrate member (14).

2. The multi-chip circuit component (10) according to claim 1, **characterized in that** the first and second substrate members (12,14) are formed of a ceramic material.

3. The multi-chip circuit component (10) according to claim 1, **characterized in that** the outer layers (26,28) of the first and second substrate members (12,14) have a solderable surface.

4. The multi-chip circuit component (10) according to claim 1, **characterized in that** the at least two circuit devices (16,18) comprise a transistor and diode or a pair of transistors.

5. The multi-chip circuit component (10) according to claim 4, **characterized in that** the at least two circuit devices (16,18) comprise a pair of insulated gate bipolar transistors.

6. The multi-chip circuit component (10) according to claim 4, **characterized in that** the at least two circuit devices (16,18) comprise a pair of field effect transistors.

7. The multi-chip circuit component (10) according to claim 1, **characterized in that** a first of the at least two circuit devices (16,18) is a transistor (18) and a second of the at least two circuit devices (16,18) is a diode (16), the first surface of the transistor (18) comprising gate and second electrodes (19,21) electrically contacting two of the electrically-conductive areas (36,38) of the first substrate member (12), the second surface of the transistor (18) comprising a third electrode electrically contacting one of the electrically-conductive areas (42) of the second substrate member (14), the first surface of the diode (16) comprising an electrode (20) electrically contacting one of the electrically-conductive areas (36) of the first substrate member (12), the second surface of the diode (16) comprising an electrode electrically contacting one of the electrically-conductive areas (40) of the second substrate member (14).

8. The multi-chip circuit component (10) according to claim 7, **characterized in that** the first lead members (32,34) comprise at least one finger (60) electrically coupled to the gate electrode (19) of the transistor (18) and at least one finger (60) electrically coupled to the second electrode (21) of the transistor (18) and to the electrode (20) on the first surface of the diode (16).

9. The multi-chip circuit component (10) according to claim 7, **characterized in that** the second lead members (30) comprise at least one finger (60) electrically coupled to the third electrode of the transistor (18) and electrically coupled to the electrode on the second surface of the diode (16).

10. The multi-chip circuit component (10) according to claim 7, **characterized in that** the transistor (18) is an insulated gate bipolar transistor.

11. The multi-chip circuit component (10) according to claim 1, **characterized in that** the multi-chip circuit component (10) is one of a plurality of substantially identical multi-chip circuit components (10) mounted to a substrate and connected in parallel to define at least one switch.

12. The multi-chip circuit component (10) according to claim 1, further comprising thermally-conductive members contacting the outer layers (26,28) of the first and second substrate members (12,14) for conducting heat from the multi-chip circuit component (10) in opposite directions through the first surfaces (22,24) of the first and second substrate members (12,14).
